Europäisches Patentamt

European Patent Office

Office européen des brevets

(19)

(11) **EP 0 433 983 B1**

(12) # EUROPEAN PATENT SPECIFICATION

(45) Date of publication and mention
of the grant of the patent:
**04.03.1998 Bulletin 1998/10**

(51) Int Cl.⁶: **H05K 3/06**, H05K 3/02, H01L 21/321

(21) Application number: **90124588.6**

(22) Date of filing: **18.12.1990**

(54) **Copper etch process using halides**

Kupfer-Aetzverfahren mit Hilfe von Haliden

Procédé de gravure de cuivre utilisant des haloides

(84) Designated Contracting States:
**DE FR GB IT NL**

(30) Priority: **20.12.1989 US 453549**

(43) Date of publication of application:
**26.06.1991 Bulletin 1991/26**

(73) Proprietor: **TEXAS INSTRUMENTS INCORPORATED**
**Dallas Texas 75265 (US)**

(72) Inventor: **Douglas, Monte A.**
**Texas 75019 (US)**

(74) Representative: **Leiser, Gottfried, Dipl.-Ing. et al**
**Prinz & Partner,**
**Manzingerweg 7**
**81241 München (DE)**

(56) References cited:
**EP-A- 175 561          EP-A- 219 697**

- **IBM TECHNICAL DISCLOSURE BULLETIN vol. 27, no. 3, August 1984, page 1490 L.CHEN ET AL 'Pulsed lamp activated chemical etching'**
- **PATENT ABSTRACTS OF JAPAN vol. 13, no. 532 (C-659)28 November 1989 & JP-A-1 215 986 ( HITACHI ) 29 August 1989**

## Description

## FIELD OF THE INVENTION

The invention concerns a process for etching copper layers, especially copper layers overlying a layer of a second material, such as found in printed circuit fabrication and the seed copper layers used in printed circuit fabrication and in integrated circuit metallization layers, by photo-formed and photo-activated halogen radicals.

## BACKGROUND OF THE INVENTION

Document EP-A-0 175 561 discloses a dry-etching method for performing anisotropic etching on a semiconductor substrate by employing an etching gas together with a film forming gas while irradiating light or an X-ray on the semiconductor substrate. The film formation gas used in this method has the purpose of achieving anisotropic etching of the silicon substrate. This method is used in connection with etching silicon and is not applied to etching of copper.

Patterning of a relatively thick copper layer or a thinner seed copper layer has been a requirement of printed circuit fabrication techniques. More recently, it has been desired to pattern thin copper layers in integrated circuit fabrication technology. Aluminum has been commonly used successfully in integrated circuit technology to form conductive leads between and across active elements of the integrated circuits, partly because aluminum has been found to be easily patterned by several techniques. However, as discussed by Hu, et al., in "Diffusion Barrier Studies for CU", 1986 IEEE V-MIC Conference, 9-10 June 1986, pages 181-187, copper offers several advantages over aluminum metallization layers in integrated circuits such as higher conductivity, better electromigration resistance, and reduced power consumption. As further discussed, however, in the same article, copper has a greater tendency to diffuse into silicon than aluminum. Satisfactory solution to this problem has, nevertheless, been found by the se of diffusion barriers between the silicon and other layers of integrated circuits and the copper metallization layers.

Patterned etching of copper films has been accomplished, primarily in printed circuit fabrication, by wet processes wherein a protective, patterned film, such as a photoresist is applied to a copper layer and then a strong liquid etchant, usually an acid, is applied to etch the exposed copper down to the base material. This process presents several problems when applied to integrated circuit fabrication, such as the following. The wet processes are inherently "dirty" in that contaminants in the etchant can be introduced to the integrated circuit wafer. The wet etchants required are generally hazardous to operators by contact and inhalation of vapors produced thereby. Etching of copper requires etchants, high temperatures, or both which may damage the other layers of an integrated circuit. Etching of copper by wet processes is isotropic, making copper metallization for VLSI circuits extremely difficult. Disposal of the waste products of wet etch processes is becoming more expensive.

Therefore, because of the increased desire to utilize copper metallization in integrated circuits and the problems inherent in known wet etch techniques, it has become more important to develop more effective etching processes and equipment for etching copper layers, especially as used in integrated circuit fabrication.

Sputtering techniques are utilized presently to remove copper from copper-doped aluminum films and therefore nay have application to removing copper films. However, sputtering, the physical dislodging of copper atoms and clusters by high energy ion bombardment, does not exhibit selective removal of various films and will result in extreme build-up of residue in the reaction chamber, since copper is not converted to a volatile species. Also, sputter removal techniques are relatively slow, difficult to control, and exhibit insufficient selectivity to masking layers.

Dry etch processes involving a plasma to form reactive agents such as a halogen, an amine, or an organic radical which react and form volatile copper products could be an approach to an effective etch process for copper which solves some of the problems encountered in other processes, particularly the redeposit of residue on reaction chambers. However, due to the known high melting and boiling points of the copper compounds that would be formed, coupled with the normal range of substrate temperatures associated with these plasma processes, it has been thought that volatilization would not occur and that these processes would be unsuccessful. Moreover, a plasma discharge produces a wide range of disassociated, reactive products that can combine homogenously or heterogeneously to form a polymer residue. For example, hydrocarbon and chlorocarbon can produce heavy residues of polymer generating many particles. Also, if the reaction product of these processes does not volatize, it has been thought that the surface reaction would prevent further reaction of the copper bulk material below this surface. Some investigation of the reaction of chlorine with copper has been done as discussed by W. Sesselmann, et al., in "The Interaction of Chlorine with Copper", Surface Science, vol. 176(1986) pages 32-90. Some early investigation of ion etching of copper films is discussed by Schwartz, et al, in "Reactive Ion Etching of Copper Films", Journal of the Electochemical Society, Vol. 130, No. 8 (1983), pages 1777-1779.

## SUMMARY OF THE INVENTION

The Inventor has found that dry or dry/wet processes using halogen ions generated and activated or energized by light and exposed to a copper film are effective processes for etching copper metallization layers, even in the environment of integrated circuit fabrication.

The Inventor has discovered that, especially at higher substrate or chamber temperatures, anisotropic volatilization of the copper halide reaction product from unmasked areas is possible. And, further, even when the copper halide product is not volatile, complete reaction of a bulk copper film with the halide ion occurs directionally or anisotropically to produce a copper halide reaction product which is easily removed anisotropically by a solvent or water wash. In either case the reaction product is removed anisotropically.

It is therefore an object of the invention to provide an etch process for copper films that is useful in fabrication processes for integrated circuits.

It is a further object of the invention to sustained patterned critical dimension definition and control in a copper etch process.

It is an object of the invention to provide an etch process for copper films which does not require a strong wet etchant.

It is a further object of the invention to provide a copper etch process that is anisotropic and can be used in integrated circuit fabrication.

It is also an object of the invention to provide for photo-induced directional diffusion of a radical through copper.

It is a further object of the invention to provide an etch process for copper films which avoids the contamination of process chambers caused by sputtering techniques.

It is a further object of the invention to provide an etch process for copper which is, essentially, a dry process. These and further benefits of the invention will be evident to one of ordinary skill in view of the drawing figures and detailed description of the embodiments to follow.

## BRIEF DESCRIPTION OF THE DRAWING FIGURES

Figure 1 is a schematic drawing of an embodiment of a reaction chamber as used in the process according to the instant invention.

Figures 2a and 2b are drawings representative of side views by electron microscopy of a semiconductor wafer during two stages of the etch process according to the instant invention.

## DETAILED DESCRIPTION OF THE INVENTION

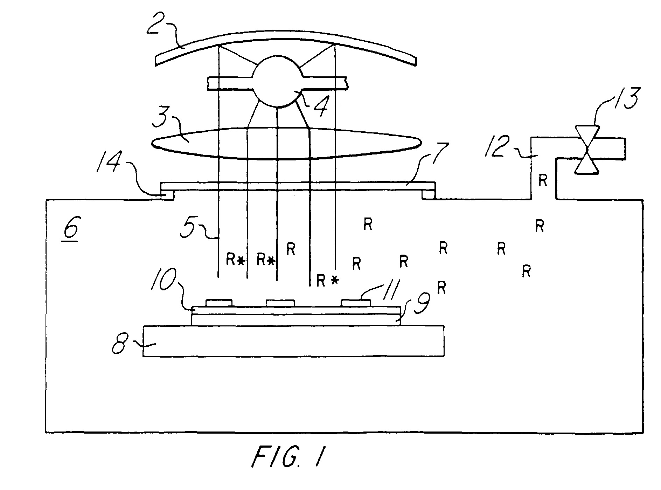

Referring to Figure 1, there is shown a sealed chamber 6 having a substrate holder 8, which normally has temperature controlled heating elements (not shown) for heating a substrate placed thereon. Shown on the substrate holder 8, is a drawing representation, not to scale, of a typical integrated circuit wafer having a substrate 9, for example a single crystal silicon substrate, a copper metal layer 10, and a patterned mask 11. Mask 11, in integrated circuit fabrication processes, would typically be a photo sensitive mask material of known types which is patterned and etched according to well-known photolithographic techniques. However, mask 11 may also be fabricated by techniques other than photolithography. Substrate holder 8 may contain controlled heating elements (not shown) for the purpose of heating the substrate 9 to a desired process temperature. The process temperature desired may be determined according to several factors. If a high degree of volatilization or complete volatilization of the combinative copper product is desired, a high process temperature is required. The exact temperature required is dependent upon the radical agent used. However, factored against utilization of such high process temperatures is the fact that the integrated circuit wafers processed may be damaged or destroyed by the temperatures required for significant volatilization. Of course, printed circuit substrates may not be so damaged by high process temperatures.

Again, referring to Figure 1, a high intensity light source 4, such as a filtered ultra violet source, e.g., a 1000 watt Hg/Xe lamp, is located above the chamber 6. Focusing elements 2 and 4 are arranged to direct the high intensity light through transparent window 7, which may be a quartz window, onto the surface of the masked copper layer 10 and 11. The window 7 is sealed, as by "0"-ring 14. It is pointed out that, although Figure 1 shows the high intensity light directed perpendicularly to the wafer, it has been found to be also effective if the chamber is arranged so that the light is directed at other angles to, and even parallel to, the wafer.

Inlet part 12, having valve 13, allows reactant R to enter the chamber 6 and contact the wafer 9, 10 and 11. Reactant R is a halogen radical-chlorine, fluorine, bromine or iodine. The halogen radical may be produced from a halogen compound, e.g., $CF_4$ by photochemical dissociation, microwave afterglow dissociation or plasma discharge dissociation, for example, as is known in the art. Also the halogen radical may be produced within the chamber by photochemical dissociation by, for example, introducing $CL_2$ to the high intensity ultraviolet light 5 from source 4. The halogen radical R may be light activated by high intensity light 5 and contacts the copper layer 10 and mask layer 11.

The etch process which occurs within the chamber 6, using a halogen radical R which may be light activated will follow two different methodologies, depending primarily upon the temperature at which the process occurs and the reactant used. As the copper layer 10 is contacted by light activated reactant R*, the copper and halogen atoms react at the surface to form a halogen copper compound. These reactions may be represented as:

## I. RADICAL FORMATION

P(gas) + hν -->R (or R*), where P is a Parent molecule, R is an amine or organic radical, and R* is a light-activated radical.

## II. RADICAL FORMATION WITH Cu

$$R + Cu_{(s)} \rightarrow CuR$$

or,

$$R^* + Cu_{(s)} \rightarrow CuR$$

or,

$$R_{ads} \cdots Cu_{(s)} + h\nu \rightarrow CuR,$$

where (g) is gas, (s) is solid.

## III. CuR REMOVAL

$$CuR + S \rightarrow CuR_{(soln)}$$

or,

$$CuR_{(ads)} \rightarrow CuR_{(g)}$$

or,

$$CuR_{(ads)} + h\nu \rightarrow CuR_{(g)},$$

where S is solvent, (soln) is solution, and (ads) is absorbed.

If CuR, under the conditions of the reaction, is volatile, then the product CuR is released as a vapor and may be pumped as a vapor from the chamber 6.

If however, product CuR is not volatile, the product remains on the copper layer surface. Surprisingly however, the Inventor has found that the reaction continues throughout the copper layer to form CuR. The surface reaction does not block reaction beneath the surface under the process conditions disclosed. After the reaction has then occurred throughout the copper layer 10, the resulting copper halogen product CuR can be washed away using an appropriate solution such as water or acetone. The copper halogen product will easily enter into solution. Moreover, the diffusion of R, in CuR to react further with copper is believed to be photo-induced directional diffusion.

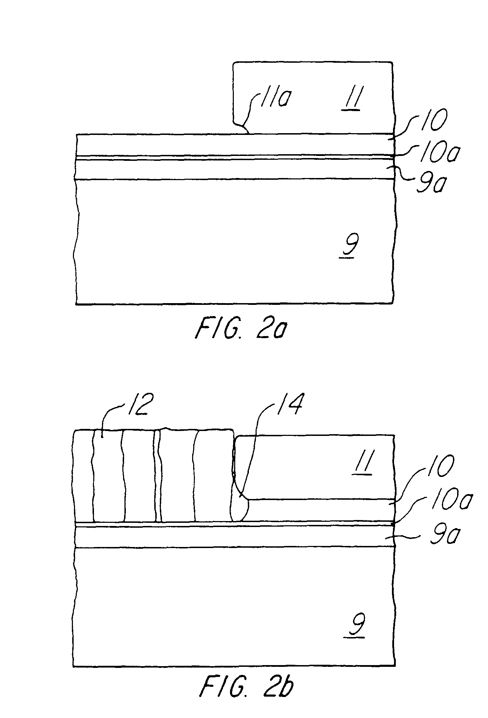

Figures 2a and 2b show a representation of an integrated circuit wafer using a copper metallization layer during two stages of the process according to the invention as has been observed by electron microscopy. The wafer of Figure 2a is shown before the etch process showing a silicon substrate 9, a silicon dioxide layer 9a, a titanium tungsten carrier layer 10a, and a copper layer 10.

A mask layer 11 is applied and patterned by well-known photolithography methods, for example, or by other known means. In this instance, a cantilevered resist overhang 11a is generated by an image-reversal development process.

Figure 2b depicts the same wafer after etch processing steps have been accomplished, as in the chamber of Figure 1, under the following conditions. The wafer (9, 10 and 11) may be deglazed as by a dilute nitric acid. A 1000 watt Mercury-Xenon lamp with a water filter was directed upon the wafer 9, 10 and 11. The water filter serves to extract most of the infrared light above 1.3nm while passing the deep ultraviolet light, down to about 200 nm. The light was directed orthogonally to the wafer. The wafer was heated to a temperature of 200 C. Molecular chlorine, $Cl_2$, was introduced to the chamber, at 10 torr, at the rate of 100 sccm. The $Cl_2$ was photo-dissociated by the photo energy of the light source to generate Cl ion radicals. The wafer was exposed to the chlorine radical for 10 minutes. After this time, Figure 2b shows that the entire copper layer which was not masked has reacted and expanded to about three times its previous thickness. The resulting product layer film 12 was found to be $CuCl_2$. Further, a void 14, due to the initial resist profile, can be noted. The resulting film may be removed by a simple wash step. The reaction products are typically removed with an acetone or water wash. Note that the copper is not etched laterally where the resist contacts the copper filem surface.

It is pointed out that the invention has been disclosed with respect to embodiments which are not intended to be limiting. It is intended that the parameters suggested in these embodiments may be varied within certain latitudes to achieve desired results. The scope of the invention, therefore, is intended to be limited only by the appended claims.

## Claims

1. A process for anisotropically etching a copper layer (10) on a substrate (9) in a closed chamber (6) to form patterned conductors comprising the steps of:

   masking areas of said copper layer (10), with contact of a mask thereto, which are not intended to be etched;

   introducing a halogen radical to only the unmasked portion of said copper layer (10) in said closed chamber (6);

   directing unpatterned light toward the copper layer (10) so as to activate the halogen radical and completely convert the unmasked portion of said copper layer (10) to form a copper halogen reaction product after said halogen radical has been irradiated by high intensity light, wherein said copper halogen reaction product remains on a surface of the unmasked portion of said copper layer (10) while said copper layer (10) is completely converted; and

washing said substrate (9) to remove said copper halogen reaction product.

2. The process of claim 1 further comprising the step of:
heating said substrate (9) to a temperature at which said copper halogen reaction product is substantially volatile.

3. The process of claim 2 wherein said substrate (9) is heated above 200°C.

4. The process of claim 1 wherein said halogen radical is a chlorine radical.

5. The process of claim 1 wherein said high intensity light is ultraviolet light.

6. The process of claim 1 further comprising the step of introducing a halogen gas to said closed chamber such that said light creates said halogen radical from said halogen gas.

7. The process of claim 1 wherein said light is emitted by a Mercury-Xenon lamp.

**Patentansprüche**

1. Verfahren zum anisotropen Ätzen einer Kupferschicht (10) auf einem Substrat (9) in einer geschlossenen Kammer (6) zur Bildung strukturierter Leiter, bei welchem:

Bereiche der Kupferschicht (10), die nicht geätzt werden sollen, durch Kontakt mit einer Maske maskiert werden;

in der geschlossenen Kammer (6) ein Halogenradikal nur den unmaskierten Bereichen der Kupferschicht (10) zugeführt wird;

unstrukturiertes Licht gegen die Kupferschicht (10) gelenkt wird, so daß das Halogenradikal aktiviert wird und der unmaskierte Bereich der Kupferschicht (10) vollständig zur Bildung eines Kupferhalogen-Reaktionsprodukts umgewandelt wird, nachdem das Halogenradikal mit Licht hoher Intensität bestrahlt worden ist, wobei das Kupferhalogen-Reaktionsprodukt auf einer Fläche des unmaskierten Bereich der Kupferschicht (10) bleibt, während die Kupferschicht (10) vollständig umgewandelt wird; und

das Substrat (9) zum Entfernen des Kupferhalogen-Reaktionsprodukts gewaschen wird.

2. Verfahren nach Anspruch 1, bei welchem ferner: das Substrat (9) auf eine Temperatur erwärmt wird, bei der das Kupferhalogen-Reaktionsprodukt im wesentlichen flüchtig ist.

3. Verfahren nach Anspruch 2, bei welchem das Substrat (9) auf über 200°C erwärmt wird.

4. Verfahren nach Anspruch 1, bei welchem das Halogenradikal ein Chlorradikal ist.

5. Verfahren nach Anspruch 1, bei welchem das Licht hoher Intensität Ultraviolettlicht ist.

6. Verfahren nach Anspruch 1, bei welchem ferner ein Halogengas in die geschlossene Kammer geleitet wird, so daß das Licht aus dem Halogengas das Halogenradikal erzeugt.

7. Verfahren nach Anspruch 1, bei welchem das Licht von einer Quecksilber-Xenon-Lampe ausgestrahlt wird.

**Revendications**

1. Procédé d'attaque anisotropique d'une couche de cuivre (10) sur un substrat (9) dans une chambre fermée (6) pour former des conducteurs configurés, comprenant les étapes consistant à :

- masquer des zones de ladite couche de cuivre (10), par contact d'un masque avec celles-ci, qui ne sont pas destinées à être attaquées,
- introduire un radical halogène à uniquement la portion non masquée de ladite couche de cuivre (10) dans ladite chambre fermée (6),
- diriger une lumière non configurée vers la couche de cuivre (10) de manière à activer le radical halogène et convertir complètement la portion non masquée de ladite couche de cuivre (10) pour former un produit de réaction halogène-cuivre après que ledit radical halogène a été irradié par une lumière d'intensité élevée, dans lequel ledit produit de réaction halogène-cuivre reste sur une surface de la portion non masquée de ladite couche de cuivre (10), tandis que ladite couche de cuivre (10) est complètement convertie, et
- laver ledit substrat (9) pour retirer ledit produit de réaction halogène-cuivre.

2. Procédé selon la revendication 1, comprenant en outre l'étape de chauffer ledit substrat (9) à une température à laquelle ledit produit de réaction halogène-cuivre est substantiellement volatile.

3. Procédé selon la revendication 2, dans lequel ledit substrat (9) est chauffé au-dessus de 200°C.

4. Procédé selon la revendication 1, dans lequel ledit radical halogène est un radicaux de chlore.

5. Procédé selon la revendication 1, dans lequel ladite lumière d'intensité élevée est de la lumière ultraviolet.

6. Procédé selon la revendication 1, comprenant en outre l'étape d'introduire un gaz halogène dans ladite chambre fermée, de manière que ladite lumière crée ledit radical halogène à partir dudit gaz halogène.

7. Procédé selon la revendication 1, dans lequel ladite lumière est émise par une lampe au Xenon-Mercure.

FIG. 1

*FIG. 2a*

*FIG. 2b*